Europäisches Patentamt

European Patent Office

Office européen des brevets

(19)

(11) Numéro de publication : **0 076 736 B1**

(12) **FASCICULE DE BREVET EUROPÉEN**

(45) Date de publication du fascicule du brevet :
16.04.86

(51) Int. Cl.⁴ : **H 03 H 19/00**

(21) Numéro de dépôt : **82401753.7**

(22) Date de dépôt : **28.09.82**

(54) **Circuit intégré à caractéristique inductive, et filtre utilisant ce circuit.**

(30) Priorité : 02.10.81 FR 8118636

(43) Date de publication de la demande :
13.04.83 Bulletin 83/15

(45) Mention de la délivrance du brevet :
16.04.86 Bulletin 86/16

(84) Etats contractants désignés :
DE FR GB IT NL

(56) Documents cités :
EP-A- 0 024 011
ELECTRONICS LETTERS, vol. 14, no. 24, 23 novembre 1978, pages 788-790, Londres, G.B. B.J. HOSTICKA et al.: "Switched-capacitor simulation of grounded inductors and gyrators"

(73) Titulaire : **SOCIETE POUR L'ETUDE ET LA FABRICATION DE CIRCUITS INTEGRES SPECIAUX - E.F.C.I.S.**
**17, avenue des Martyrs**
**F-38100 Grenoble (FR)**

(72) Inventeur : **Sokoloff, Boris**
**THOMSON-CSF SCPI 173, bld Haussmann**
**F-75379 Paris Cedex 08 (FR)**

(74) Mandataire : **Guérin, Michel et al**
**THOMSON-CSF SCPI 19, avenue de Messine**
**F-75008 Paris (FR)**

Jouve, 18, rue St-Denis, 75001 Paris, France

## Description

La présente invention concerne les circuits intégrés, et plus particulièrement le domaine des filtres.

On sait depuis longtemps qu'on peut réaliser certaines fonctions de transfert de filtres en utilisant des circuits passifs en échelle ne comprenant que des inductances et des capacités, ce type de circuit permettant d'obtenir des bandes passantes très étroites avec une très forte réjection en dehors de la bande passante et une relative insensibilité aux variations des valeurs d'inductances et de capacités.

Malheureusement, les inductances ne sont pas réalisables selon les techniques de fabrication de circuits intégrés, surtout si elles doivent présenter une forte valeur.

Comme il est essentiel, pour des raisons d'encombrement, de pouvoir disposer de filtres entièrement intégrés sur de très petites surfaces de semiconducteur, on évite généralement d'utiliser des schémas de filtres utilisant des inductances et on se tourne vers des filtres purement actifs. Leur inconvénient majeur est le nombre élevé d'amplificateurs opérationnels qu'ils nécessitent : au moins n amplificateurs pour un filtre d'ordre n. Ces filtres sont souvent des filtres à capacités commutées, c'est-à-dire que toutes les résistances ont été remplacées par des capacités commutées à haute fréquence comme cela a été expliqué dans deux articles de IEEE Journal of Solid State Circuits, volume SC-12, n° 6, décembre 1977, pages 592 à 607 (Caves et autres, Hosticka et autres).

Selon la présente invention, on réalise de manière particulièrement simple un élément de circuit entièrement intégrable qui présente une caractéristique d'inductance pouvant avoir une valeur très élevée (plusieurs henrys), cet élément pouvant être associé à d'autres éléments de circuit pour réaliser des filtres bâtis sur des schémas de filtres passifs en échelle à inductances et capacités.

Un exemple de schéma d'inductance simulée intégrable est présenté dans le brevet EP-A-0 024 011. Il comprend pour l'essentiel un amplificateur opérationnel, trois capacités et cinq interrupteurs travaillant selon un cycle de quatre phases distinctes.

La présente invention propose un circuit plus simple encore puisqu'il ne comprend pour l'essentiel outre l'amplificateur opérationnel, que deux capacités et trois interrupteurs travaillant selon un cycle de trois phases. Le tout est intégrable de préférence selon une technologie MOS (métal-oxyde-semiconducteur) : il existe depuis longtemps de bons amplificateurs opérationnels réalisés dans cette technologie, les interrupteurs peuvent être réalisés chacun par un transistor MOS, et les capacités, de l'ordre de quelques dizaines ou centaines de picofarads, peuvent être réalisées en utilisant comme diélectrique, entre deux couches conductrices, l'oxyde mince servant à former les transistors MOS.

Le circuit intégré selon l'invention comprend, entre une première et une deuxième borne, une première capacité en série avec au moins un interrupteur apte à relier cette capacité entre les deux bornes ou à l'isoler de la première borne, le circuit comprenant encore un amplificateur opérationnel bouclé entre sa sortie et son entrée par une deuxième capacité, et d'autres interrupteurs agencés pour relier la première capacité à divers points du circuit, les divers interrupteurs étant commandés par un circuit logique de commande pour réaliser successivement, selon un cycle périodique, les connexions suivantes :

a) la première capacité est reliée entre la première borne et la deuxième borne du circuit, la sortie et l'entrée de l'amplificateur opérationnel étant reliées uniquement à la deuxième capacité pendant cette phase,

b) la première capacité est reliée entre l'entrée de l'amplificateur opérationnel et une borne de masse,

c) la première capacité est reliée entre la sortie de l'amplificateur opérationnel et la borne de masse,

d) la première capacité est à nouveau reliée entre la première et la deuxième borne.

La deuxième borne du circuit peut être confondue avec une borne de masse si, par exemple, l'inductance est montée entre une borne de signal et la masse.

Si l'inductance est insérée en série dans un circuit, il faut prévoir deux interrupteurs spécifiques pour relier la première capacité soit à la masse (étapes b, c), soit à la deuxième borne du circuit (étapes a et d).

On verra dans la description détaillée de l'invention que la valeur de l'inductance est égale à $Cl/Co^2 f^2$ si $Co$ et $Cl$ sont les valeurs des première et deuxième capacités et $f$ la fréquence du cycle répétitif de commande des interrupteurs.

L'inductance étant en principe utilisée en combinaison avec une capacité pour réaliser des circuits bouchons dont la fréquence de résonance dépend du produit de l'inductance par la capacité, on voit que cette fréquence sera essentiellement fonction d'un rapport de capacités. Or, on sait réaliser, en technologie MOS des rapports de capacités très précis même si on ne sait pas réaliser des valeurs absolues de capacités précises. Par ailleurs, la fréquence de commutation $f$ peut, elle aussi, être très bien connue, de sorte que les filtres LC réalisés avec cette inductance simulée auront des fréquences de résonance pouvant être très précisément définies.

Parmi les avantages de cette inductance simulée, on peut citer le fait qu'elle permet de réaliser un filtre d'ordre n comprenant pratiquement deux fois moins d'amplificateurs opérationnels qu'un filtre actif de même ordre. D'autre part, il n'est pas du tout nécessaire d'utiliser des amplificateurs à hautes performances. En particulier, si leur gain est faible, on aura l'équivalent d'une inductance à coefficient de surtension fini, parfaitement utilisable dans un filtre passif en échelle. Enfin, l'élément de circuit selon l'invention est sensiblement plus simple (moins de capacités et de commutateurs) que les circuits qui ont jusqu'à maintenant été imaginés pour essayer de réaliser des inductances simulées (article de Nossek et Temes dans IEEE Transactions on Circuits and Systems vol. CAS-27 n° 6 juin 1980). Il ne nécessite en particulier que trois phases d'horloge à chaque cycle.

D'autres caractéristiques et avantages de l'invention apparaîtront à la lecture de la description détaillée qui suit et qui est faite en référence aux dessins annexés dans lesquels :

la figure 1 représente le schéma du circuit selon l'invention, équivalant à une inductance pouvant être placée entre une borne de signal et une borne de masse,

les figures 2a, 2b et 2c représentent les trois phases du cycle de fermeture des interrupteurs à chaque période du circuit de commande de commutation,

la figure 3 représente une variante de réalisation pour une inductance à mettre en série dans un circuit,

la figure 4 représente un filtre en échelle classique,

la figure 5 représente le même filtre transposé selon l'invention.

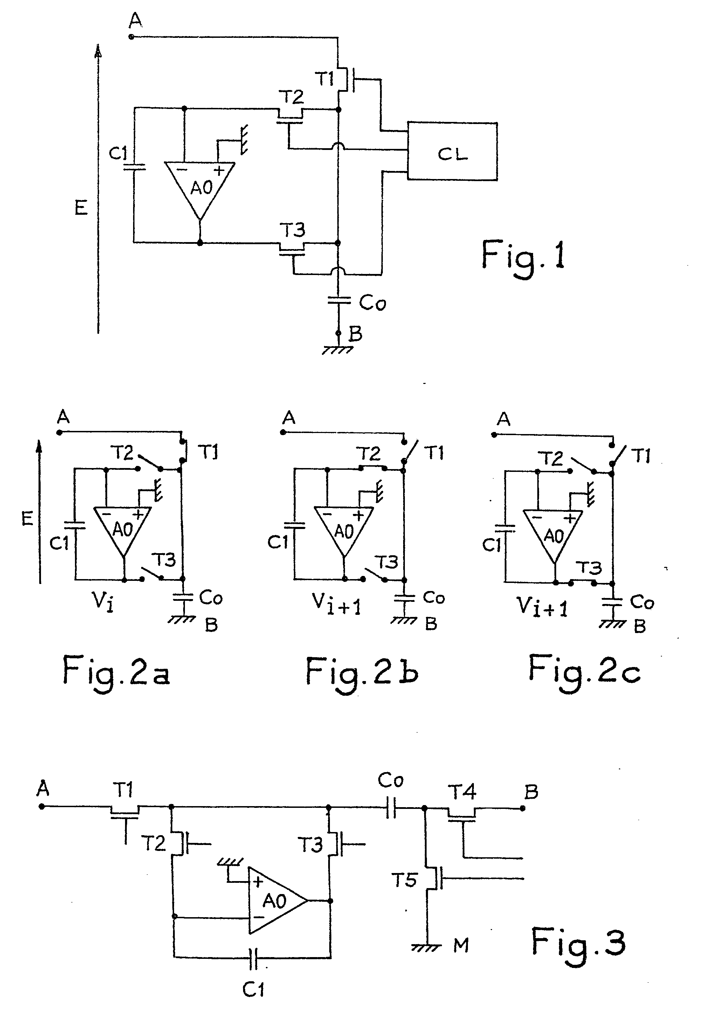

Le circuit de l'invention, représenté à la figure 1, possède deux bornes A et B, la borne B étant ici reliée à la masse pour réaliser un circuit simulant une inductance reliée entre une borne de signal (la borne A) et la masse.

Le circuit comprend une première capacité Co en série avec un interrupteur constitué ici par un transistor à grille isolée (MOS), T1, cet ensemble en série étant connecté entre les bornes A et B.

Un deuxième interrupteur, également constitué et représenté par un transistor MOS, T2, est connecté entre le point de jonction de la capacité Co et du transistor T1 et l'entrée inverseuse d'un amplificateur opérationnel A0 (dont l'entrée non inverseuse est à la masse).

Un troisième interrupteur, constitué et représenté par un transistor MOS, T3, est connecté entre la sortie de l'amplificateur opérationnel et le point de jonction entre la première capacité Co et les transistors T1 et T2.

Une seconde capacité C1 est connectée entre la sortie et l'entrée inverseuse de l'amplificateur opérationnel A0 pour servir de contre-réaction capacitive à cet amplificateur.

Enfin, un circuit logique de commande de commutation, CL, commande les grilles des trois transistors pour les rendre conducteurs ou les bloquer selon un cycle périodique à une fréquence f de commutation nettement supérieure aux fréquences probables des signaux appliqués à la borne A.

Le cycle de commande est tel que les transistors soient rendus conducteurs pendant des intervalles de temps disjoints, c'est-à-dire qu'un seul transistor à la fois est conducteur pendant chaque phase du cycle.

Les durées de conduction de chaque transistor correspondent donc à une fraction de la période du cycle de commutation.

Ce cycle est explicité aux figures 2a, 2b et 2c qui représentent respectivement la première, la deuxième et la troisième phase du cycle de commutation à la fréquence f.

Pour expliquer ce fonctionnement et pour montrer par un calcul simple en quoi le circuit se comporte comme une inductance placée entre les bornes A et B, on supposera :

qu'une tension E est appliquée entre les bornes A et B, cette tension provenant d'une source de tension à impédance quasiment nulle,

que la tension en sortie de l'amplificateur A0 à la fin d'un $i^{ième}$ cycle de commutation est $V_i$,

et que la tension aux bornes de la capacité Co à la fin du cycle i est également $V_i$ ; ce dernier point résulte, comme on le verra, du fait qu'effectivement la dernière phase d'un cycle consiste à charger la capacité Co à la valeur de tension présente en sortie de l'amplificateur opérationnel.

La première phase du cycle suivant, c'est-à-dire du cycle i + 1, consiste à rendre conducteur le transistor T1 (les autres étant bloqués). La capacité Co se charge alors à la tension E ; cette charge s'effectue très rapidement car la capacité a une faible valeur, et elle est terminée avant que le transistor ne se bloque. Par exemple, si la capacité est de l'ordre de 100 picofarads, en série avec des impédances de source, d'interrupteurs, etc. de 1 000 ohms, on voit qu'il faut prévoir une durée de fermeture d'une fraction de microseconde, ce qui donne un aperçu de l'ordre de grandeur maximum de la fréquence f du cycle de commutation.

La charge reçue par la capacité Co est égale à Co (E—$V_i$) puisqu'elle passe d'une tension $V_i$ à une tension E. Comme ce sera la seule charge circulant dans la borne de signal A pendant le cycle i + 1, puisque l'interrupteur T1 sera ensuite ouvert pour toute la durée du cycle, on peut dire que pendant la durée T de ce cycle (T = 1/f), il aura circulé un courant moyen Co (E—$V_i$)/T.

Pendant cette première phase, la tension de sortie $V_i$ de l'amplificateur A0 n'a pas varié car on suppose qu'il s'agit d'un amplificateur opérationnel parfait à impédance d'entrée infinie et gain élevé, et la capacité de bouclage C1, chargée à la tension $V_i$, n'a pas pu se décharger.

Pendant la deuxième phase (figure 2b), après que le transistor T1 se soit bloqué, le transistor T2 est rendu conducteur. Ceci a pour effet d'appliquer brusquement la charge CoE de la première capacité à l'entrée de l'amplificateur opérationnel. Le bouclage de celui-ci par la capacité C1 provoque le transfert de toute la charge de la capacité Co dans la capacité C1 pour ramener à zéro la tension entre les entrées inverseuse et non inverseuse de l'amplificateur. Ce transfert se fait avec un signe négatif, c'est-à-dire que si la tension E est positive par rapport à la masse, la

tension $V_i$ aux bornes de la capacité sera réduite.

La charge de la capacité C1 était initialement C1$V_i$. Elle devient donc C1$V_i$ — CoE. Comme la tension à l'entrée inverseuse de l'amplificateur est ramenée à zéro (potentiel de l'entrée non inverseuse), c'est la tension de sortie de l'amplificateur qui varie et qui devient $V_{i+1}$ telle que :

$$C1v_{i+1} = C1V_i - CoE$$

où

$$V_{i+1} = V_i - E\ Co/C1.$$

La troisième phase (figure 2c) consiste alors à appliquer cette nouvelle tension à la capacité Co. Pour cela, on ouvre l'interrupteur constitué par le transistor T2 et on ferme celui qui est constitué par le transistor T3. La capacité Co est ainsi reliée entre la sortie (à $V_{i+1}$) de l'amplificateur et la masse. On notera que la capacité Co se charge à $V_{i+1}$ sans que la capacité C1 se décharge (et donc sans modifier la tension de sortie $V_{i+1}$) car la capacité C1 est en série avec l'impédance d'entrée supposée infinie de l'amplificateur AO.

On se trouve donc à la fin du cycle i+1 et donc au début du cycle i+2 avec une situation initiale nouvelle où la capacité Co n'est plus chargée à la tension $V_i$ mais à la tension $V_{i+1} = V_i - ECo/C1$. Ceci signifie que lorsqu'on fermera à nouveau l'interrupteur T1 pour charger Co à la tension E (dont on suppose qu'elle n'a pas varié entre deux périodes consécutives du cycle de commutation), la charge qui circulera dans la borne de signal sera Co (E — $V_{i+1}$) c'est-à-dire Co (E — $V_i$) + 2ECo²/C1,

De même, à la fin du cycle i+2, elle sera Co(E—$V_i$+₂), c'est-à-dire Co(E—$V_i$) + 2ECo²/C1, et ainsi de suite : à chaque période, la charge qui circule augmente de ECo²/C1 ; le courant moyen qui est égal à cette charge divisée par la période T augmente donc d'une constante ECo²/C1T à chaque période.

Cette croissance régulière en escalier, qui s'assimile à une croissance linéaire de courant si on se place à une fréquence nettement plus basse que la fréquence de commutation correspond exactement au fonctionnement d'une inductance, c'est-à-dire que la variation de courant par unité de temps dI/dt est proportionnelle à la tension appliquée à l'inductance : E = LdI/dt.

Ici, dI pendant une période T est égal à ECo²/C1T donc dI/T = ECo²/C1T².

On est en présence d'une inductance équivalente de valeur L = C1T²/Co²E ou L = C1/Co²f².

Un ordre de grandeur simple explique l'intérêt de ce circuit : si f = $10^5$ hertz, C1 = Co = 100 picofarads ($10^{-10}$ farads), alors L = 1 henry. Cette valeur peut être augmentée par réduction des valeurs de capacités mais alors on devient sensible à la présence de capacités parasites du même ordre de grandeur, ou par réduction de la fréquence de commutation, mais alors on est limité par la fréquence des signaux que l'on peut appliquer à la borne de signal A.

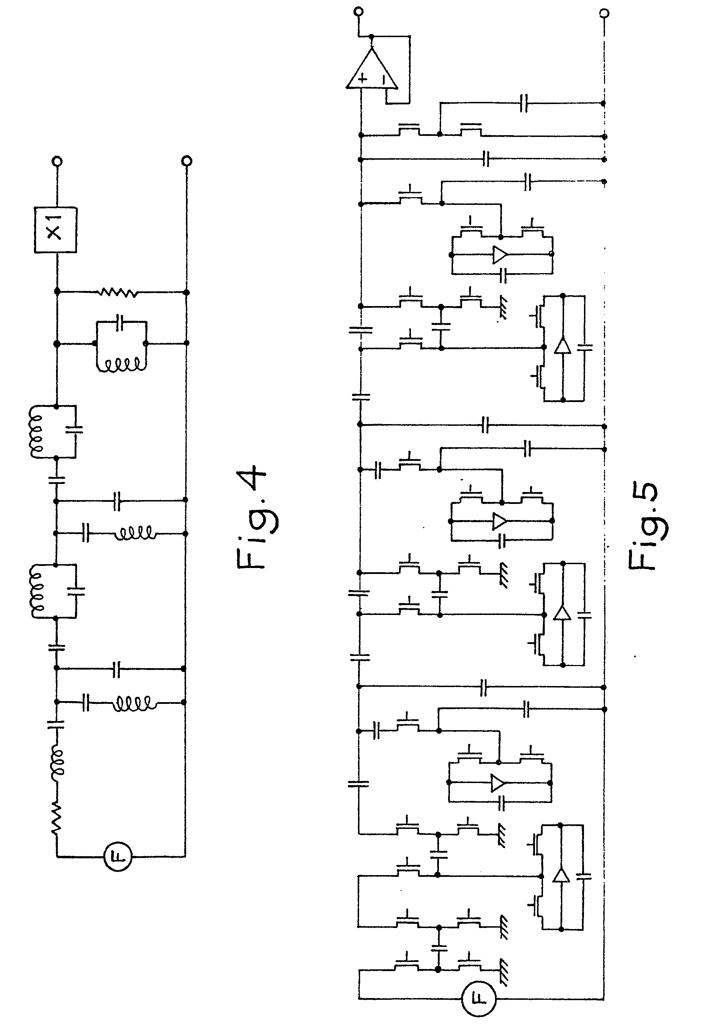

La figure 3 représente une variante de réalisation de circuit destiné à remplacer une inductance en série entre deux points dont aucun ne constitue une masse du circuit ou un point de référence de tension fixe.

On a donc représenté séparément une borne de masse M (à laquelle est toujours connectée l'entrée non inverseuse de l'amplificateur opérationnel A0), et une borne B qui constitue, de même que la borne A, une borne de l'inductance équivalente que l'on cherche à réaliser.

Le circuit de la figure 3 est le même que celui de la figure 2 à l'exception de la liaison entre la première capacité Co et la borne B : cette liaison était directe dans la figure 2 ; à la figure 3, cette liaison se fait à travers un quatrième interrupteur (transistor T4) vers la borne B et à travers un cinquième interrupteur (transistor T5) vers la masse. Les transistors T4 et T5 sont commandés, de même que les transistors T1, T2 et T3, par le circuit logique CL non représenté à la figure 3.

Le fonctionnement diffère de celui de la figure 2 en ce sens que la première phase comprend en plus le blocage du transistor T5 et la mise en conduction du transistor T4, tandis que la deuxième et la troisième phase comprennent la mise en conduction du transistor T5 et le blocage du transistor T4 après que le transistor T1 ait été bloqué. Les phases de mise en conduction des transistors T4 et T5 sont disjointes pour qu'il n'y ait pas risque de mise à la masse de la borne B. De même, celles de mise en conduction de T1 et T5 sont disjointes, comme celles de T1, T2, celles de T1, T3 et celles de T2, T3.

La figure 4 montre à titre d'exemple un filtre passif classique du 12ème ordre (filtre passe-bande) utilisant un réseau d'inductances et de capacités en échelle, et la figure 5 montre un filtre qui en est la transposition selon l'invention, dans lequel les résistances ont été remplacées par des capacités commutées et les inductances par des circuits conformes à la figure 1 ou 3. Comme on le voit, le nombre d'amplificateurs opérationnels de ce filtre du douzième ordre n'est que de six (en plus de l'adaptateur d'impédance à la sortie). Le circuit logique CL de commande de commutation des divers interrupteurs n'est pas représenté à la figure 5.

**Revendications**

1. Circuit intégré présentant une caractéristique d'inductance, réalisé à partir de capacités commutées et d'un amplificateur opérationnel, caractérisé par le fait qu'il comprend, entre une première et une deuxième borne (A, B), une première capacité (Co) en série avec au moins un interrupteur (T1) apte à relier cette capacité entre les deux bornes ou à l'isoler de la première borne, le circuit comprenant encore un amplificateur opérationnel (A0) bouclé entre sa sortie et son entrée par une deuxième capacité (C1), et d'autres interrupteurs (T2, T3, T4, T5) agencés pour relier la première capacité à divers points du circuit, les divers interrupteurs étant commandés par un circuit logique de commande (CL) pour réaliser successivement, selon un cycle périodique, les connexions suivantes :

a) la première capacité est reliée entre la première borne (A) et la deuxième borne (B) du circuit, la sortie et l'entrée de l'amplificateur opérationnel étant reliées uniquement à la deuxième capacité pendant cette phase,

b) la première capacité est reliée entre l'entrée de l'amplificateur opérationnel et une borne de masse (M),

c) la première capacité est reliée entre la sortie de l'amplificateur opérationnel et la borne de masse (M),

d) la première capacité est à nouveau reliée entre la première et la deuxième borne.

2. Circuit selon la revendication 1, caractérisé par le fait que la deuxième borne du circuit est une borne de masse.

3. Circuit selon la revendication 1, caractérisé par le fait que la deuxième borne n'est pas une borne de masse et que deux interrupteurs (T5, T4) sont spécifiquement prévus pour relier la capacité soit à la masse (étapes b, c) soit à la deuxième borne (étapes a et d).

4. Filtre réalisé sous forme de circuit intégré utilisant un réseau de capacités d'une part et de circuits selon l'une des revendications 1 à 3, d'autre part.

**Claims**

1. An integrated circuit having an inductance characteristic and conceived on the basis of switched capacitors and of an operational amplifier, characterized in that said circuit comprises between a first and a second terminal (A, B) a first capacitor (Co) in series with at least one switch (T1) which is capable either of inserting said capacitor between the two terminals or of insulating it from said first terminal, the circuit further comprising an operational amplifier (A0) having a feedback connection via a second capacitor (C1) between its output and its input, and additional switches (T2, T3, T4, T5) adapted to connect the first capacitor to different points of the circuit, the different switches being controlled by a logic control circuit (CL) for successively establishing the following connections according to a periodic cycle :

a) the first capacitor is inserted between the first terminal (A) and the second terminal (B) of the circuit, the output and the input of the operational amplifier being connected only to the second capacitor during this phase ;

b) the first capacitor is inserted between the input of the operational amplifier and a ground terminal (M),

c) the first capacitor is inserted between the ouput of the operational amplifier and the ground terminal (M),

d) the first capacitor is again inserted between the first and the second terminal.

2. A circuit according to claim 1, characterized in that the second terminal of the circuit is a ground terminal.

3. A circuit according to claim 1, characterized in that the second terminal is not a ground terminal and that two switches (T5, T4) are specifically provided for connecting the capacitor either to ground (steps b, c) or to the second terminal (steps a et d).

4. A filter constructed in the form of an integrated circuit using a network of capacitors on the one hand and of circuits according to one of claims 1 to 3 on the other hand.

**Ansprüche**

1. Integrierte Schaltung mit induktivem Verhalten, die geschaltete Kondensatoren und einen Operationsverstärker enthält, dadurch gekennzeichnet, daß zwischen einem ersten und einem zweiten Anschluß (A, B) ein erster Kondensator (Co) in Reihe mit mindestens einem Schalter (T1) angeordnet ist, der diesen Kondensator zwischen diese beiden Anschlüsse legen oder vom ersten Anschluß isolieren kann, wobei der Schaltkreis außerdem einen Operationsverstärker (A0), der einen zweiten Kondensator (C1) zwischen seinem Ausgang und seinem Eingang besitzt, und weitere Schalter (T2, T3, T4, T5) aufweist, die den ersten Kondensator an verschiedene Punkte des Schaltkreises anschließen, wobei die verschiedenen Schalter von einem logischen Steuerkreis (CL) so gesteuert werden, daß in einem periodischen Zyklus die folgenden Verbindungen hergestellt werden :

a) der erste Kondensator wird zwischen den ersten Anschluß (A) und den zweiten Anschluß (B) des Schaltkreises geschaltet, wobei während dieser Phase der Ausgang und der Eingang des Operationsverstärkers nur mit dem zweiten Kondensator verbunden sind,

b) der erste Kondensator ist an den Eingang des Operationsverstärkers und an einen Masseanschluß (M) angeschlossen,

c) der erste Kondensator liegt zwischen dem Ausgang des Operationsverstärkers und dem Masseanschluß (M),

d) der erste Kondensator wird erneut zwischen den ersten und zweiten Anschluß eingeschaltet.

2. Schaltkreis nach Anspruch 1, dadurch gekennzeichnet, daß der zweite Anschluß des Schaltkreises eine Masseklemme ist.

3. Schaltkreis nach Anspruch 1, dadurch gekennzeichnet, daß der zweite Anschluß keine Masseklemme ist und daß zwei Schalter (T5, T4) speziell vorgesehen sind zur Verbindung des Kondensators mit Masse (Schritte b, c) oder mit dem zweiten Anschluß (Schritte a und d).

4. Filter in Form einer integrierten Schaltung, die ein Netz von Kondensatoren einerseits und Schaltkreisen gemäß einem der Ansprüche 1 bis 3 andererseits verwendet.

Fig.1

Fig.2a   Fig.2b   Fig.2c

Fig.3

1

Fig.4

Fig.5